# EUROPEAN PATENT APPLICATION

(11) **EP 1 705 966 A2**
(43) Date of publication of application: **27.09.2006**
(21) Application number: 06111653.9
(22) Date of filing: 23.03.2006
(51) Int. Cl.: H05K 1/02, H05K 1/05, H01L 23/14, H01L 23/373

(54) **Circuit board and manufacturing method thereof**

(30) Priority: 25.03.2005 JP 2005089337
(71) Applicant: KABUSHIKI KAISHA TOYOTA JIDOSHOKKI, Kariya-shi, Aichi 448-8671 (JP)
(72) Inventor: Tanaka, Katsufumi, Kariya-shi Aichi 448-8671 (JP); Kinoshita, Kyoichi, Kariya-shi Aichi 448-8671 (JP); Kono, Eiji, Kariya-shi Aichi 448-8671 (JP)
(74) Representative: TBK-Patent

(57) **Abstract**

A circuit board has a base plate (1), an insulating layer (2) and a conductive circuit portion (3). The insulating layer is fixed to the base plate. The insulating layer includes a resin layer. The conductive circuit portion is fixed to the insulating layer on a side opposite to the base plate. The base plate and the conductive circuit portion have substantially the same coefficient of linear expansion and the same thickness.

## Description

### TECHNICAL FIELD

The present invention relates to a circuit board used for various electronic instruments, such as an inverter and a power supply circuit.

With the high-density packaging of electronic devices in recent years, heat generated by devices on a circuit board has been increasing. An increase in temperature of electronic devices affects the characteristics and life of the devices and, therefore, reduces the overall reliability of electronic instruments. This increase in temperature with high-density packaging is highlighted in the field of power circuits. To improve the reliability of power circuits, it is an important task to help dissipate the heat from the heat generating devices. For this reason, a power circuit uses such a circuit board that a conductive circuit pattern is formed on a high thermal conductive metal base plate through an insulating layer. When a circuit pattern is formed on a metal base plate through an insulating layer for heat dissipation, there can be a warpage because of a difference in coefficient of linear expansion between the heat generating devices and the circuit pattern and between the heat generating devices and the base plate. This has caused electronic components to be broken in the worst case.

To ensure efficient heat dissipation while preventing board warpage, a circuit board made of a combination of materials with a low coefficient of linear expansion has been developed. For example, the circuit board shown in FIG. 3 is disclosed in the unexamined Japanese patent application publication No. 2004-24156. This circuit board is formed so that 0.5 mm thick Al is brazed on the both sides of 0.6 mm thick AIN ceramic insulating layer 20 to form a circuit portion 30 and an insert layer 30' and the insert layer 30' is then brazed onto a 5 mm thick Cu-Mo base plate 10. In other word, this circuit board uses Cu-Mo having a low coefficient of expansion in addition to the structure of AI/AIN/AI having a low coefficient of expansion. However, there has been a problem that AIN for the insulating layer and Mo for the base plate are expensive and are not economical.

The present invention is directed to providing a circuit board that reduces the board warpage due to thermal stress without using an expensive material having a low coefficient of linear expansion.

### SUMMARY

In accordance with the present invention, a circuit board has a base plate, an insulating layer and a conductive circuit portion. The insulating layer is fixed to the base plate. The insulating layer can include a resin layer. The conductive circuit portion is fixed to the insulating layer on a side opposite to the base plate. The base plate and the conductive circuit portion have substantially the same coefficient of linear expansion and thickness.

Other aspects and advantages of the invention will become apparent from the following description, taken in conjunction with the accompanying drawings, illustrating by way of example the principles of the invention.

### BRIEF DESCRIPTION OF THE DRAWINGS

The features of the present invention that are believed to be novel are set forth with particularity in the appended claims. The invention together with objects and advantages thereof, may best be understood by reference to the following description of the presently preferred embodiments together with the accompanying drawings in which:
FIG. 1 is a cross-sectional view of a circuit board according to a first preferred embodiment of the present invention;
FIG. 2 is a cross-sectional view of a circuit board according to a second preferred embodiment of the present invention; and
FIG. 3 is a cross-sectional view of a circuit board according to the prior art.

### DETAILED DESCRIPTION OF THE PREFERRED EMBODIMENTS

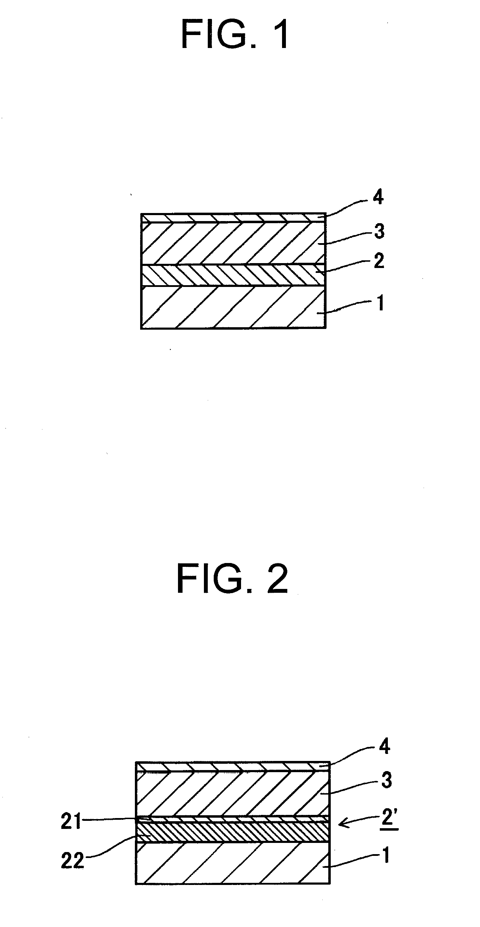

The following will describe a first preferred embodiment of a circuit board according to the present invention with reference to FIG. 1. In this description, one component having substantially the same coefficient of linear expansion as the other means that one component may have up to 5 % above or below the coefficient of linear expansion of the other. Likewise, one component having substantially the same thickness as the other means that one component may have up to 5 % above or below the thickness of the other.

FIG. 1 illustrates the cross-sectional view of the circuit board according to the first preferred embodiment. In FIG. 1, the reference numerals 1, 2, 3 and 4 indicate a base plate, an insulating layer, a circuit portion and a heat spreader.

The base plate 1 desirably has a high thermal conductivity for improving heat dissipation. The base plate 1 may be made of alloy or composite material including metal. However, it is preferably made of simple metal, such as Cu and Al, which are inexpensive. Not taking cost into consideration, the base plate 1 may be made of Ag or Au. The base plate 1 should be thick for higher heat dissipation. However, the base plate 1 having a thickness of 10 mm or less is preferable for saving weight and lowering cost.

The circuit portion 3 is made of material having a low electric resistivity and the same coefficient of linear expansion as the base plate 1. For this reason, when the base plate 1 is made of Cu, the circuit portion 3 is desirably made of Cu. The circuit portion 3 has substantially the same thickness as the base plate 1. If the base plate 1 has a thickness of 2.5 mm, the circuit portion 3 should have a thickness of 2.375 to 2.625 mm.

The insulating layer 2 is preferably made of resin. The resin desirably has high insulation properties and high thermal conductivity. For example, epoxy resin mixed with inorganic filler, such as Al₂O₃ powder and AIN power, is preferable for the resin. The insulating layer 2 should have a smaller thickness in view of thermal conductivity but have a greater thickness in view of insulation properties. Thus, the insulating layer 2, for example, can have a thickness of 100 to 200 µm.

The heat spreader 4 desirably has a low electric resistivity and low coefficient of linear expansion. The heat spreader 4 is, for example, made of composite material of Cu and Invar as expanded metal. Invar is a nickel/iron alloy, for example, with 36 % nickel. The term of "expanded metal" in this composite material means that a metal plate is alternately slit and expanded to form a mesh, which is, for example, disclosed in the unexamined Japanese patent application publication No. 2003-152144. This composite material has a coefficient of linear expansion of 5 X 10⁻⁶/°C. This relatively small coefficient is due to the coefficient of linear expansion of Invar, which is 1 X 10⁻⁶/°C. This composite material has an electric resistivity of 2.5 µohm-cm, which is as small as that of Al. This relatively small resistivity is due to the electric resistivity of Cu, which is 1.7 µ Ω-cm. The heat spreader 4, for example, has a thickness of 0.5 mm.

The base plate 1, the insulating layer 2 and the circuit portion 3 are fixed, for example, by hot pressing. In hot pressing, the base plate 1, the insulating layer 2 and the circuit portion 3 are superimposed and then pressed while being heated in vacuo, thereby fixing them. When the insulating layer 2 is made of epoxy resin, they may be fixed by pressing under a pressure of 4 MPa at a temperature of 170 °C for 1 hour. The heat spreader 4 may be fixed to the circuit portion 3 on the side opposite to the insulating layer 2 by soldering, brazing or diffusion bonding.

The following will describe a second preferred embodiment of the present invention with reference to FIG. 2.

FIG. 2 illustrates the cross-sectional view of a circuit board according to the second preferred embodiment. In the first preferred embodiment depicted in FIG. 1, the insulating layer 2 only includes a resin layer. The circuit board in the second preferred embodiment depicted in FIG. 2 differs from that of the first preferred embodiment in that the insulating layer 2' includes a resin layer 21 and an inorganic insulating film 22. The same reference numerals denote the same or similar components to the first preferred embodiment, and the description is omitted.

The resin layer 21 is, for example, made of epoxy resin mixed with inorganic filler, such as Al₂O₃ powder or AIN powder. It can have a thickness of several dozen µm. In this case, insulation properties are provided not by the resin layer 21 but by the inorganic insulating film 22, so that the resin layer 21 is preferably made as thin as possible.

The inorganic insulating film 22 is made of AIN, Si₃N₄, Al₂O₃, or the like. It can have a thickness of 100 to 200 µm. The inorganic insulating film 22 is formed on the base plate 1 by sputtering, chemical vapor deposition (CVD), physical vapor deposition (PVD), or the like. Then, resin is applied between the inorganic insulating film 22 and the circuit portion 3 as an adhesive to form the resin layer 21. The inorganic insulating film 22 and this resin layer cooperate to form the insulating layer 2'. In an alternative embodiment, the inorganic insulating film 22 may be formed on the bottom of the circuit portion 3.

Resin generally has a lower thermal conductivity than ceramic or metal, so that the resin layer 21 has a lower thermal conductivity than ceramic or metal. However, in this embodiment, since the insulating layer 2' includes not only the resin layer 21 but also the inorganic insulating film 22, the resin layer 21, which is environmentally degradable and low in thermal conductivity, may be thinner and the insulation layer 2' as a whole has insulation properties. Thus, the circuit board is resistant to environmental degradation.

### [Example 1]

This example 1 describes the circuit board according to the first preferred embodiment shown in FIG. 1. The base plate 1 is a Cu plate with a coefficient of linear expansion of 17.6 X 10⁻⁶/°C. It has a thickness of 2.5 mm. The insulating layer 2 is made of epoxy resin containing Al₂O₃ powder. It has a thickness of 150 µm. The circuit portion 3 is a Cu plate with a coefficient of linear expansion of 16.8 X 10⁻⁶/°C. It has a thickness of 2.5 mm. The heat spreader 4 is a composite material that includes Invar and Cu. It has a coefficient of linear expansion of 5 X 10⁻⁶/°C and a thickness of 0.5 mm.

### [Example 2]

This example 2 describes the circuit board according to the second preferred embodiment shown in FIG. 2. The base plate 1, the circuit portion 3, the heat spreader 4 are the same as those of the Example 1. The resin layer 21 is made of epoxy resin containing Al₂O₃ powder. It has a thickness of 50 µm, which is a third as thick as the insulating layer 2 of the Example 1. The inorganic insulating film 22 is made of Si₃N₄ with a thickness of 100 µm.

### [Comparative Example 1]

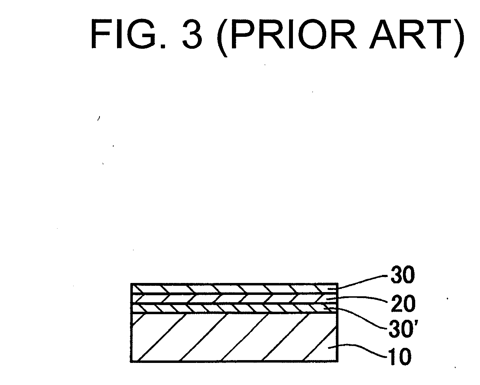

This comparative example 1 describes the circuit board according to the prior art shown in FIG. 3. The base plate 10 is made of Cu-Mo with a thickness of 5 mm. The insulating layer 20 is made of AIN with a thickness of 0.6 mm. The circuit portion 30 and the insert 30' are made of Al with a thickness of 0.5 mm.

### [Comparative Example 2]

The comparative example 2 differs from the comparative example 1 in that the base plate 10 was made of Cu.

A semiconductor chip (transistor) is soldered onto the heat spreader 4 of the examples 1 and 2 and onto the circuit portions 30 of the comparative examples 1 and 2, respectively, and the thermal resistances of these chips are then measured. The results of the measurements are shown in TABLE 1. Thermal resistances are calculated from the measured current magnitude and temperature difference between the chip and the base plate during energization of the chip.

**TABLE 1**

| | Example 1 | Example 2 | Comparative Example 1 | Comparative Example 2 |
|---|---|---|---|---|
| Thermal Resistance (°C/W) | 0.62 | 0.58 | 0.65 | 0.63 |

The results shown in TABLE 1 affirm that the circuit boards of the examples 1 and 2 have equivalent or lower thermal resistances than those of the comparative examples 1 and 2. In conclusion, it has been demonstrated that the circuit boards according to the examples 1 and 2 have lower thermal resistances and higher heat dissipation properties without using an expensive AIN insulating layer or a base plate including expensive Mo as in the comparative examples 1 and 2.

Therefore, the present examples and embodiments are to be considered as illustrative and not restrictive. The invention is not to be limited to the embodiments described herein. It is to be understood that other similar embodiments may be used or modifications and additions may be made to the described embodiments for performing the same function. Therefore, the claimed invention should not be limited to any single embodiment, but rather should be construed in breadth and scope in accordance with the appended claims.

A circuit board has a base plate, an insulating layer and a conductive circuit portion. The insulating layer is fixed to the base plate. The insulating layer includes a resin layer. The conductive circuit portion is fixed to the insulating layer on a side opposite to the base plate. The base plate and the conductive circuit portion have substantially the same coefficient of linear expansion and thickness.

## Claims

1. A circuit board comprising a base plate, an insulating layer fixed to the base plate and a conductive circuit portion fixed to the insulating layer on a side opposite to the base plate, **characterized in that** the insulating layer includes a resin layer, and **in that** the base plate and the conductive circuit portion have substantially the same coefficient of linear expansion and thickness.

2. The circuit board according to claim 1, wherein the insulating layer includes an inorganic insulating film.

3. The circuit board according to claim 2, wherein the inorganic insulating film has a thickness of 100 to 200 µm.

4. The circuit board according to any one of claims 2 and 3, wherein the inorganic insulating film is made of material selected from the group consisting of AIN, Si₃N₄ and Al₂O₃.

5. The circuit board according to claim 1, wherein the insulating layer is made of epoxy resin mixed with inorganic filler.

6. The circuit board according to claim 5, wherein the inorganic filler is made of material selected from the group consisting of Al₂O₃ powder and AIN powder.

7. The circuit board according to any one of claims 1 through 6, wherein the insulating layer has a thickness of 100 to 200 µm.

8. The circuit board according to any one of claims 1 through 7, **characterized in that** a conductive heat spreader is fixed to the conductive circuit portion on a side opposite to the insulating layer.

9. The circuit board according to claim 8, wherein the conductive heat spreader is made of Cu and Invar as expanded metal.

10. The circuit board according to any one of claims 1 through 9, wherein the base plate is made of simple metal.

11. The circuit board according to claim 10, wherein the base plate is made of material selected from the group consisting of Cu and Al.

12. The circuit board according to any one of claims 1 through 11, wherein the base plate has a thickness of 10 mm or below.

13. The circuit board according to any one of claims 1 through 12, wherein the base plate and the conductive circuit portion each have a thickness of 1 mm or above.

14. A method of manufacturing a circuit board including a base plate and a conductive circuit portion having substantially the same coefficient of linear expansion and thickness, the base plate and the conductive circuit portion being connected through an insulating layer, comprising the steps of:
depositing an inorganic insulating film on either one of the base plate and the conductive circuit portion by chemical vapor deposition, physical vapor deposition or sputtering; and
adhering a surface of the inorganic insulating film to the other of the base plate and the conductive circuit portion with resin.

15. The method according to claim 15, further comprising the step of:
fixing a conductive heat spreader to the conductive circuit portion on a side opposite to the insulating layer by soldering, brazing or diffusion bonding.
